Europäisches Patentamt

European Patent Office

Office européen des brevets

(19)

(11) Numéro de publication: **0 097 087 B1**

# (12) FASCICULE DE BREVET EUROPEEN

(45) Date de publication du fascicule du brevet:
30.04.86

(21) Numéro de dépôt: 83401143.9

(22) Date de dépôt: 03.06.83

(51) Int. Cl.⁴: **H 01 L 23/16,** H 01 L 23/04, H 01 L 23/24

(54) Boîtier à capot plastique pour composants semi-conducteurs.

(30) Priorité: 15.06.82 FR 8210404

(43) Date de publication de la demande:
28.12.83 Bulletin 83/52

(45) Mention de la délivrance du brevet:
30.04.86 Bulletin 86/18

(84) Etats contractants désignés:
**AT BE CH DE FR GB IT LI LU NL SE**

(56) Documents cités:
**FR - A - 2 235 488**

(73) Titulaire: **LE SILICIUM SEMICONDUCTEUR SSC,
101, Boulevard Murat, F-75016 Paris (FR)**

(72) Inventeur: **Doutey, Maurice, THOMSON-CSF
SCPI 173, bld Haussmann, F-75379 Paris Cedex 08 (FR)**

(74) Mandataire: **Guérin, Michel et al, THOMSON-CSF
SCPI 19, avenue de Messine, F-75008 Paris (FR)**

## Description

La présente invention concerne un boîtier pour composants semiconducteurs comprenant une embase métallique et un capot en matière plastique venant s'appuyer sur l'embase. Elle sera plus particulièrement décrite dans le cas d'un composant semiconducteur destiné à fonctionner en haute fréquence bien qu'elle ne soit pas limitée à cette application.

Dans le domaine des composants semiconducteurs haute fréquence, par exemple les transistors HF, on utilise généralement des boîtiers dans lesquels le composant est contenu dans une enceinte étanche renfermant une atmosphère choisie, cette enceinte étant constituée par des parties de céramique et de métal et comprenant donc des scellements du type verre-métal. De tels scellements sont relativement coûteux.

Un objet de la présente invention est de prévoir un boîtier particulièrement économique pour des composants et plus particulièrement des composants haute fréquence, du type couramment appelé boîtier plastique, comprenant une embase métallique sur laquelle repose un capot en matière plastique, l'enceinte ainsi formée étant remplie d'une matière isolante durcissable.

Ce type de boîtier plastique est couramment utilisé pour les composants semiconducteurs de puissance non destinés à fonctionner à très haute fréquence. Pour les adapter au domaine des hautes fréquences, il se pose des problèmes particuliers étant donné que ces composants sont souvent très fragiles et supportent mal le rétreint de la matière durcissable lors du durcissement de celle-ci. D'autre part, dans les composants haute fréquence, il existe souvent de très nombreux fils de connexion entre certaines des plages métallisées du composant et les connecteurs de sortie. Le positionnement mutuel de ces divers fils conducteurs constitue l'un des moyens de réglage de la fréquence de fonctionnement du composant HF. Si l'on utilise un boîtier plastique habituel, lors du rétreint de la substance durcissable, le positionnement mutuel des divers fils conducteurs est modifié et la fréquence de fonctionnement du composant HF est modifiée.

Ainsi, dans la technique classique, on a évité d'utiliser des boîtiers plastique pour les composants HF ou bien on a cherché à obtenir des substances durcissables présentant un rétreint pratiquement nul lors de leur durcissement, recherches qui n'ont pas abouti ou qui ont conduit à l'emploi de substances durcissables extrêmement coûteuses, ce qui est au contraire au but recherché, à savoir d'obtenir des boîtiers économiques.

Ainsi, pour atteindre ces objets, le boîtier selon la présente invention est caractérisé en ce qu'il comprend un cadre en matériau élastique de périmètre inférieur à celui du capot et supérieur au périmètre externe du composant la face inférieure de ce cadre prenant appui sur l'embase et la face supérieure étant pressée par la face inférieure de la paroi supérieure du capot, la zone comprise entre la périphérie externe de ce cadre et les parois latérales internes du capot étant remplie d'une substance isolante durcissable adhérant à ces parois et au fond du boîtier.

Dans un mode de réalisation plus particulier, la présente invention prévoit un boîtier pour un composant semiconducteur disposé sur une plaquette électriquement isolante et thermiquement conductrice placée sur une embase métallique, cette plaquette comprenant des plages métallisées en nombre au moins égal à celui des bornes du composant et auxquelles ces bornes sont reliées, les pattes d'une grille de connexion venant en contact avec ces plages métallisées et un capot en matière plastique venant s'appuyer sur l'embase, une paroi latérale de ce capot étant ouverte pour laisser le passage à ces pattes, ce boîtier étant caractérisé en ce qu'il comprend un cadre en matière élastique entourant le composant, la face inférierure de ce cadre prenant appui sur la plaquette et sa face supérieure étant pressée par la paroi supérieure du capot. L'enceinte définie par l'embase et le capot est remplie d'une substance isolante durcissable à l'extérieur de la zone délimitée par le cadre.

De préférence, les parois du cadre sont biseautées de façon que la face inférieure de chaque paroi se réduise sensiblement à une arête.

Ainsi, selon la présente invention, on profite des avantages d'économie des boîtiers de plastique, tout en évitant d'enrober le composant semiconducteur lui-même dans une matière durcissable, ce composant demeurant dans l'air ou tout autre gaz contrôlé, et la bulle de gaz étant séparée de l'atmosphère externe par une enceinte étanche, constituée par le fond du boîtier, la surface supérieure du capot, et le cadre entouré d'un anneau constitué d'une matière isolante durcissable à l'état durci.

Ces objets, caractéristiques et avantages ainsi que d'autres de la présente invention seront exposés plus en détail dans la description suivante d'un mode de réalisation particulier faite en relation avec les figures jointes parmi lesquelles :

– la figure 1 représente une vue en perspective explosée des principales pièces servant à constituer un boîter selon l'invention,

– la figure 2 représente une vue en perspective et en coupe partielle d'un boîtier selon la présente invention,

– la figure 3 est une vue en coupe d'un boîtier selon la présente invention.

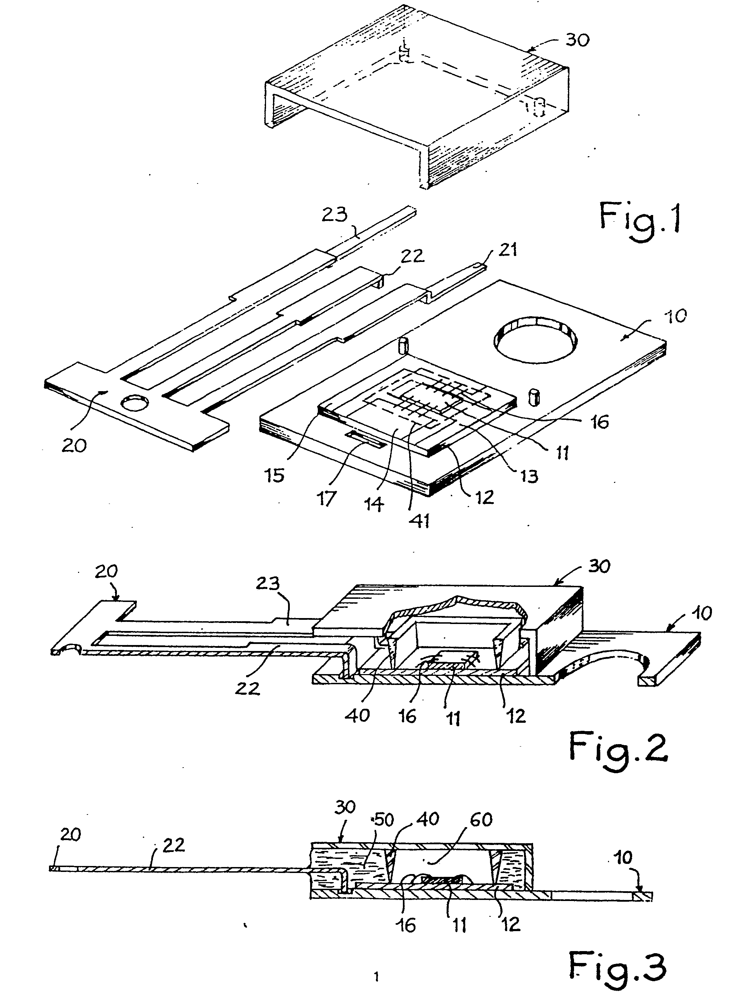

La figure 1 représente un boîtier du type couramment désigné par l'appellation normalisée TO220 auquel on va appliquer la présente invention. Ce boîtier comprend une embase 10 sur laquelle est montée la face arrière d'un composant semiconducteur 11. Dans l'exemple représenté, le composant semiconductuer n'est pas soudé directement sur l'embase 10, mais repose sur une plaque de céramique isolante 12 dont la face inférieure en contact avec l'embase est uniformément métallisée et dont la face supérieure comprend plusieurs plages métallisées : une première plage 13 sur laquelle est soudée la face arrière du composant 11, une deuxième plage 14 correspondant à une borne du composant et une troisième plage 15 correspondant à une autre borne du composant. Dans le cas où le composant semiconducteur est un composant haute fréquence, on retrouve souvent de multiples connexions par des fils d'or fin 16 depuis l'une de bornes du composant vers l'une des plages métallisées. Le boîtier comprend également une grille de connexion 20 munie de trois pattes de connexion 21, 22 et 23 destinées à venir respectivement en contact électrique avec les plages métallisées 13, 14 et 15. Les pattes 21 et 23 reposent directement sur les plages 13 et 15 auxquelles elles sont soudées alors que la patte 22 vient se loger dans une encoche 17 de l'embase 10 et est raccordée à la plage métallisée 14 par de la soudure. Enfin, le boîtier comprend un capot en matière plastique 30 comportant éventuellement des moyens de positionnement solidaires de moyens de positionnement correspondants de l'embase 10, par exemple des picots et des encoches.

Pour monter un boîtier du type de celui de la figure 1, on soude les pattes de connexion sur les parties correspondantes de l'embase, puis on positionne le boîtier et l'on remplit l'enceinte déterminée par le capot, la face avant étant ouverte, d'une matière isolante thermodurcissable couramment appelée, parfois à tort, résine. Quand le composant semiconducteur est un composant HF, cette dernière étape de montage de boîtier, à savoir le remplissage d'une résine durcissable, pose de nombreuses difficultés. En effet, le positionnement relatif des divers fils d'or extrêmement fragiles 16 est couramment un moyen pour régler la fréquence d'accord du composant. Lors de la coulée de résine ou lors du rétreint de celle-ci, les fils d'or 16 sont amenés à se déplacer et le composant est désaccordé. On a donc considéré jusqu'à preésent qu'il n'était pas possible d'utiliser des boîtiers plastique avec encapsulage de résine pour monter des composants semiconducteurs haute fréquence. On a néanmoins essayé de coller les faces inférieures des parois latérales du capot 30 sur l'embase 10 et de boucher l'ouverture béante du capot par une résine thermodurcissable qui ne pénètrerait pas jusqu'au composant. Ceci pose de nombreuses difficultés pratiques, notamment du fait de la présence des pattes de connexion 21, 22 et 23 relativement épaisses que la résine doit cerner pour rendre l'enceinte étanche. Il faut donc choisir une résine dans un état ni trop mou, ni trop dur pour qu'elle puisse quand même couler autour des pattes de connexion sans pénétrer dans le boîtier jusqu'au composant. On est donc arrivé à des procédés difficilement réalisables industriellement.

Ainsi, selon la présente invention, comme le montre la figure 2, il est prévu, après soudure de la grille de connexion et avant la pose du capot, de disposer autour de composant et des fils minces de connexion 16 un cadre 40 en matière élastique, par exemple en élastomère. La zone de contact entre ce cadre et la surface de la plaque isolante 12 est représentée par un trait en pointillés 41 en figure 1. Ce cadre a de préférence une forme biseautée pour que l'arête inférieure appuyant sur la plaque 12 ait une élasticité particulièrement bonne propre à épouser les différences de niveau sur la surface d'appui, ces différences de niveau étant par exemple liées aux métallisations et même, dans certains cas autres que celui représenté, au franchissement d'une patte de connexion.

Une fois le cadre 40 mis en place, on positionne le capot 30 dont la face supérieure vient presser la face supérieure du cadre de façon à le maintenir en position. On peut alors, comme le représente la figure 3, remplir de façon classique l'intérieur du capot 30 d'une substance isolante durcissable, par exemple une résine époxy 50. On trouve alors le composant 11 disposé dans une enceinte étanche 60 délimitée latéralement par le cadre 40 et la résine 50 qui assure l'étanchéité, la paroi supérieure de cette enceinte étant constituée par la paroi supérieure du capot 30 et la paroi inférieure de l'enceinte par l'embase 10 ou tout élément, tel que la plaque isolante 12, fixé sur celle-ci. On cumule ainsi les avantages du faible coût lié à l'emploi de boîtiers plastiques aux avantages liés aux boîtiers métalliques dans lesquels le composant n'est pas au contact direct d'une substance isolante susceptible de présenter un rétreint et de polluer ou de déformer le composant ou ses fils de connexion.

Ainsi, si la présente invention a d'abord été conçue pour l'application particulière décrite ci-dessus aux composants haute fréquence, on notera qu'elle est susceptible de nombreuses autres applications dans de boîtiers plastiques de types différents de celui représenté, car de façon générale les phénomènes liés au rétreint de la résine peuvent entraîner des contraintes sur le composant semiconducteur qui nuisent à sa fiabilité. On pourra imaginer que l'élément élastique 40, au lieu d'être un simple cadre en élastomère, peut être une cloche, c'est-à-dire comprendre une paroi supérieure maintenue directement ou indirectement par la paroi supérieure d'un boîtier plastique.

**Revendications**

1. Boîtier pour composant semiconducteur comprenant une embase métallique (10) et un capot en matière plastique (30) venant s'appuyer sur l'embase, caractérisé en ce qu'il comprend un cadre (40) en matériau élastique de périmètre inférieur à celui du capot et supérieur à celui du composant la face inférieure de ce cadre prenant appui sur l'embase et la face supérieure étant pressée par la face inférieure de la paroi supérieure du capot, la zone comprise entre la périphérie externe du cadre et les parois latérales du capot étant remplie d'une substance isolante durcissable adhérant à ces parois et au fond du boîtier.

2. Boîtier pour composant semiconducteur disposé sur une plaquette (12) électriquement isolante et thermiquement conductrice placée sur une embase métallique (10), cette plaquette comprenant des plages métallisées (13, 14, 15) en nombre au moins égal à celui des bornes du composant et auxquelles ces bornes sont reliées, des pattes (21, 22, 23) d'une grille de connexion (20) venant en contact avec ces plages métallisées, un capot (30) en matière plastique venant s'appuyer sur l'embase, une portion latérale de ce capot étant ouverte pour laisser le passage aux-dites pattes, caractérisé en ce qu'il comprend un cadre (40) en matière élastique entourant le composant (11), la face inférieure de ce cadre prenant appui sur la plaquette et la face supérieure étant pressée par la face inférieure de la paroi supérieure du capot.

3. Boîtier selon la revendication 2, caractérisé en ce que l'enciente définie par l'embase et le capot est remplie d'une substance isolante (50) à l'extérieur de la zone (60) délimitée par le cadre.

4. Boîtier selon l'une des revendications 1, 2 ou 3, caractérisé en ce que les parois du cadre sont biseautées, de sorte que la face inférieure du cadre s'appuyant du côté de l'embase soit sensiblement réduite à une succession d'arêtes.

**Patentansprüche**

1. Gehäuse für Halbleiter mit einer metallischen Grundplatte (10) und einer Schutzkappe (30) aus Kunststoff, die sich auf der Grundplatte abstützt, dadurch gekennzeichnet, daß ein Rahmen (40) aus elastischem Material vorgesehen ist, dessen Umfang kleiner ist als der Umfang der Schutzkappe und größer als der Umfang des Halbleiters, wobei die Unterseite des Rahmens sich auf der Grundplatte abstützt und auf siene Oberseite durch die Unterseite der oberen Wand der Schutzkappe Druck ausgeübt wird und der zwischen dem Außenumfang des Rahmens und den Wänden der Schutzkappe befindliche Bereich mit einer aushärtbaren Isoliermasse gefüllt ist, die an die Wände und an den Boden des Gehäuses anhaftet.

2. Gehäuse für einen Halbleiter, der auf einer elektrisch isolierenden und thermisch leitenden Platte (12) angeordnet ist, die auf eine metallische Grundplatte (10) aufgesetzt ist, wobei die Platte metallisierte Bereiche (13, 14, 15) in einer Anzahl aufweist, die wenigstens gleich derjenigen der Anschlußleiter des Halbleiters ist, wobei an die Anschlußleiter weitere Anschlußleiter (21, 22, 33) eines Verbindungsgitters (20) angeschlossen sind, die in Kontakt mit den metallisierten Bereichen stehen, wobei sich ferner eine Schutzkappe (30) aus Kunststoff auf der Grundplatte abstützt und ein seitlicher Teil der Schutzkappe für den Durchtritt der weiteren Anschlußleiter offen ist, dadurch gekennzeichnet, daß ein Rahmen (40) aus elastischem Material den Halbleiter (11) umgibt, wobei die Unterseite des Rahmens sich auf der Platte abstützt und auf seine Oberseite durch die Unterseite der oberen Wand der Schutzkappe Druck ausgeübt wird.

3. Gehäuse nach Anspruch 2, dadurch gekennzeichnet, daß die von der Grundplatte und der Schutzkappe ausgebildete Einschließung außerhalb des vom Rahmen begrenzten Bereiches (60) mit einem Isoliermittel (50) gefüllt ist.

4. Gehäuse nach Anspruch 2 oder 3, dadurch gekennzeichnet, daß die Wände des Rahmens derart abgeschrägt sind, daß die sich auf der Fläche der Grundplatte abstützende Unterseite des Rahmens etwa auf eine Folge von Kanten verringert ist.

**Claims**

1. Housing for a semiconductor component comprising a metallic base (10) and a hood (30) of plastics material carried by said base, characterized in that it comprises a frame (40) of resilient material having a perimeter smaller than that of the hood and exceeding that of the component, the bottom face of this frame bearing on the base and the upper face being exposed to pressure from the lower face of the top wall of the hood, the zone comprised between the outer periphery of the frame and the lateral walls of the hood being filled with an insulating curable substance adhering to these walls and to the bottom of the housing.

2. Housing for a semiconductor component arranged on an electrically insulating and thermally conductive plate located on a metallic base (10), this plate comprising metallized lands (13, 14, 15) the number of which is at least equal to that of the terminals of the component and whereto these terminals are connected, fingers (21, 22, 23) of a connection grid (20) contacting these metallized lands, a hood (30) of plastics material bearing on the base, a lateral portion of this hood being open to permit said fingers to pass, characterized in that it comprises a frame (40) of resilient material surrounding the component (11), the lower face of this frame bearing on the plate and the upper face being exposed to pressure by the lower face of the top wall of the hood.

3. Housing according to claim 2, characterized in that the chamber defined by the base and the hood is filled with an insulating substance (50) outside of the zone (60) defined by the frame.

4. Housing according to any of claims 1, 2, and 3, characterized in that the walls of the frame are bevelled in such a manner that the lower face of the frame bearing on the side of the base is substantially reduced to a succession of edges.

1/1

Fig.1

Fig.2

Fig.3